# EUROPÄISCHE PATENTSCHRIFT

(11) **EP 2 726 692 B1**
(45) Veröffentlichungstag und Bekanntmachung des Hinweises auf die Patenterteilung: **15.04.2015**
(21) Anmeldenummer: 12730885.6
(22) Anmeldetag: 21.06.2012
(51) Int. Cl.: H03K 17/955, B60R 25/00

(54) **KAPAZITIVE SENSORANORDNUNG UND VERFAHREN ZUR ERFASSUNG VON BETÄTIGUNGSGESTEN AN EINEM KRAFTFAHRZEUG**
CAPACITIVE SENSOR AND METHOD FOR DETECTING CONTROL GESTURES FOR A MOTOR VEHICLE
CAPTEUR CAPACITIF ET MÉTHODE POUR DÉTECTER DES GESTES DE COMMANDE POUR UN VÉHICULE À MOTEUR

(30) Priorität: 29.06.2011 DE 102011051434
(43) Veröffentlichungstag der Anmeldung: 07.05.2014
(73) Patentinhaber: Huf Hülsbeck & Fürst GmbH & Co. KG, 42551 Velbert (DE)
(72) Erfinder: VAN GASTEL, Peter, 42699 Solingen (DE); GERDES, Bernd, 45355 Essen (DE)
(74) Vertreter: Zenz Patentanwälte Partnerschaft mbB
(86) Internationale Anmeldenummer: PCT/EP2012/061921
(87) Internationale Veröffentlichungsnummer: WO 2013/000805

(56) Entgegenhaltungen:
- EP-A1- 1 980 450
- EP-A2- 1 978 642
- DE-A1-102009 025 212
- US-A- 5 394 292
- US-A- 5 914 610
- US-A1- 2010 271 047

## Beschreibung

Die Erfindung betrifft eine kapazitive Sensoranordnung zur Erfassung von Annäherungen und Bewegungsgesten eines Benutzers an einem Kraftfahrzeug sowie ein zugehöriges Verfahren.

Eine kapazitive Sensoranordnung ist mit einer Steuereinrichtung gekoppelt, die eine Änderung der Kapazität der Sensoranordnung gegenüber einem Referenzpotential erfasst. Die Sensoranordnung umfasst wenigstens zwei Sensorelektrodenanordnungen, die an räumlich versetzten Positionen am Kraftfahrzeug angeordnet sind, wobei die Sensorelektroden als längliche Elektrodenanordnungen ausgebildet und mit gleicher Raumorientierung angeordnet sind und wobei die Steuer- und Auswerteeinrichtung zur getakteten Ansteuerung der Sensorelektroden in vorgegebenen Zeitabständen ausgebildet ist.

Eine kapazitive Sensoranordnung der genannten Art ist beispielsweise aus dem US-Patent 5,730,165 bzw. der entsprechenden Patentschrift DE 196 81 725 B4 bekannt. Auch die DE 10 2010 000 271 beschreibt eine entsprechende Anordnung.

Die US 5,394,292 A offenbart eine Sensoranordnung nach dem Oberbegriff des Anspruchs 1.

Sensorelektroden werden häufig eingesetzt, um eine Tür eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten. Die DE 10 2009 025 212 offenbart ein Auswerteverfahren für derartige Anordnungen, wobei dort die Schließvorrichtung zum berührungslosen einen kapazitiven Sensor mit genau zwei Elektroden aufweist. Dies ermöglicht es, Kapazitäten der beiden Elektroden gegeneinander zu messen. Dadurch wird insbesondere keine zusätzliche Referenzkapazität benötigt, gegen die Kapazitäten einer Elektrode gemessen werden. Dies soll unter anderem den Energieverbrauch gegenüber Schließvorrichtungen mit mehr als zwei Elektroden reduzieren. Ein Problem, welches auch aus der vorgenannten Druckschrift hervorgeht, besteht darin, dass der Energieverbrauch für die regelmäßige Abfrage über längere Zeitdauer erheblich ist und das bordseitige Energiesystem belastet.

Aufgabe der Erfindung ist es, eine verlässliche Sensorik bereitzustellen, welche den Energieverbrauch bei gleicher Erkennungsgenauigkeit herabsetzt.

Erfindungsgemäß wird diese Aufgabe durch eine kapazitive Sensoranordnung mit den Merkmalen des Anspruchs 1 sowie ein Verfahren mit den Merkmalen des Anspruchs 6 gelöst.

Die erfindungsgemäße Lösung benötigt wenigstens zwei Sensorelektrodenanordnungen an räumlich versetzten Positionen am Kraftfahrzeug. Die Steuer- und Auswerteeinrichtung ist zur getakteten Ansteuerung der Sensorelektroden in vorgegebenen Zeitabständen ausgebildet.

Die Gestaltung oder Ausbildung der Sensorelektroden ist für die Erfindung nicht wesentlich. Jede der Elektroden kann drahtartig, flächig oder folienartig ausgebildet sein, wobei der Draht oder die Folie die Sensorelektrode des Kapazitätssensors bildet. Die Sensorelektrode kann sich abschnittsweise über einen Teil oder über der gesamten Breite eines Stoßfängers des Kraftfahrzeugs erstrecken. Die Sensorelektroden können Bestandteil des Stoßfängers sein oder innenseitig in diesem aufgeklebt oder mit Befestigungsmitteln befestigt sein. Ferner können die Sensorelektroden im Spritzgussprozess zur Herstellung des Stoßfängers bereits verarbeitet werden. Dabei können die Kapazitätssensoren innerhalb des Stoßfängers eine räumliche Trennung aufweisen, so dass sich der erste Kapazitätssensor eher im vertikalen Erstreckungsbereich des Stoßfängers befindet, wohingegen der zweite Kapazitätssensor vorzugsweise im unteren Bereich des hinteren Stoßfängers eingebracht ist.

Wesentlicher Aspekt der Erfindung ist, dass die Steuer- und Auswerteeinrichtung zur Ansteuerung und Auswertung der Sensorelektroden mit veränderbaren, elektrodenspezifischen Taktraten ausgebildet ist.

Im Gegensatz zu bestehenden Einrichtungen sind die Abfragefrequenzen der Sensorelektroden der Detektionseinrichtung elektrodenspezifisch, also für jede der Elektroden oder zumindest zwei Elektrodengruppen individuell bestimmbar und veränderbar. Eine oder mehrere Elektroden können also mich höhere Taktung/Frequenz (z.B. alle 30ms) abgefragt werden als andere Elektroden (z.B. alle 90ms) der Sensoranordnung.

Die Verminderung der Abfragehäufigkeit führt unmittelbar zu einer Reduzierung des Energiebedarfs. Da die Taktung reduziert wird, die Abfrage jedoch nicht über längere Zeitabschnitte ausgesetzt wird, kann auch bei geringer Taktfrequenz eine Kalibrierung der Elektroden jederzeit sichergestellt werden. Diese Kalibrierung, welche bei kapazitiven Elektroden eine Maßnahme ist, welche die Erkennungsgenauigkeit verbessert, trägt dem Umstand Rechnung, dass sich die äußeren Bedingungen (z.B. Temperatur, Luftfeuchte, Niederschlag etc.) um ein Kraftfahrzeug häufig ändern. Die Abfrage mit reduzierter Häufigkeit ist demnach erfindungsgemäß so zu wählen, dass die Veränderungen im Außenbereich in einem größeren Zeitraum auftreten, als der Zeitspanne zwischen zwei Messungen jeder der Elektroden. Dafür sind jedoch Messabstände von einigen zehn Millisekunden bis hin zu mehreren Sekunden möglich.

Jeder Elektrode, also auch die mit reduzierter Taktung abgefragten Elektroden liefern bei der Abfrage Werte, die einer zeitlichen Auswertung z.B. der Bildung eines gleitenden Mittelwertes (ggf. mit zeitlicher Gewichtung) zum Zwecke der Kalibrierung zugeführt werden. Dieser Mittelwert über den zurückliegenden Zeitraum wird bei der Prüfung eines Signals z.B. als Offset abgezogen. So bleibt die Sensitivität für eine Detektion eines zu detektierenden Ereignisses jederzeit erhalten. In einem solchen Fall wird eine signifikante Abweichung von dem gleitenden Mittelwert festgestellt.

Die Abfragefrequenz der Elektroden ist jedoch erfindungsgemäß nicht nur unterschiedlich für verschiedene Elektroden vorzugeben sondern außerdem im Betrieb veränderbar. Eine Abfragetaktung einzelner Elektroden wird in Abhängigkeit von beliebigen Ereignissen/Triggern erhöht, wenn eine zeitkritische Detektion erfolgen soll. Bei Ausbleiben entsprechender Ereignisse wird die Taktrate verringert.

Erfindungsgemäß wird durch die Steuereinrichtung eine Elektrode mit höherer Taktung als die übrigen Elektroden betrieben und ausgewertet, auch wenn die anderen Elektroden mit reduzierter Frequenz betrieben werden. Kommt es zur Auslösung in dieser Elektrode, können die weiteren Elektroden in einen Betrieb mit höherer Taktung geschaltet werden. Diese Elektrode, als Primärelektrode oder Weckelektrode zu bezeichnen, wird also als Trigger für die übrigen Elektroden genutzt, welche mit geringerer Taktung betrieben werden. Wird andererseits bei einer oder mehreren Elektroden für eine vorgegebene Zeitdauer keine Betätigung erfasst, können diese Elektroden in einen Betrieb mit geringerer Frequenz geschaltet werden. Dabei kann jede Elektrode, z.B. in Abhängigkeit von ihrer Anordnung am Fahrzeug, unterschiedliche Frequenzen für den reduzierten Betrieb (eco mode) und den geweckten Betrieb (alert mode) aufweisen.

Auf welche Art die Auswertung der Sensorelektroden erfolgt ist beliebig, wesentlich ist, dass eine Änderung der Kapazität der Sensorelektroden erfasst wird. Diese Erfassung kann erfolgen, indem die Steuerschaltung die Sensorelektroden mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotential, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein.

Es besteht bei der erfindungsgemäßen Anordnung und dem zugehörigen Verfahren die Möglichkeit, die Sensorelektroden zur Überwachung unterschiedlicher, ggf. überlappender Raumbereiche einzusetzen. Die Sensorelektroden können dafür gleichartig oder auch unterschiedlich ausgebildet sein.

Die Sensorelektrodenanordnungen werden z.B. in einem Heckstoßfänger angeordnet, um den Bereich hinter dem Stoßfänger und unter dem Stoßfänger zu überwachen. Die Signalmuster der ersten Sensorelektrode und der weiteren Sensorelektrodenanordnung werden wiederholt abgefragt (z.B. in Reaktion auf die Detektion eines ID-Gebers von einem Keyless-Entry-System). Eine vorgegebene Geste eines Benutzers, z.B. ein angetäuschter Kick unter den Stossfänger, soll zu einem Öffnungs- oder Schließvorgang führen. Dafür werden die Signalfolgen der Sensorelektroden erfasst und mit Signalfolgen verglichen, welche eine gezielte Betätigung der Einrichtung anzeigen.

Aus dieser Darstellung ergibt sich jedoch, dass eine ununterbrochene und hochfrequente Abfrage aller Erfassungsräume nicht erforderlich ist. Eine Detektion einer Betätigung ist nämlich nur bei Vorliegen von konsistenten Daten von mehreren Elektroden möglich, z.B. der passenden Signalfolge von verschiedenen Elektroden. Ein Körperteil eines Bedieners, z.B. der Fuß, wird zunächst in einem Erfassungsbereich wahrgenommen, der nur einer Untergruppe der Elektroden zugeordnet ist. Bei fortgesetzter Bewegung gelangt der Fuß in andere oder weitere Detektionsbereiche. Durch die Erfindung kann eine Gruppe der Elektroden mit höherer Frequenz abgefragt werden. Wird bei diesen Elektroden eine mögliche Betätigung registriert, werden die anderen, im energiereduzierten Modus befindlichen Elektroden geweckt und deren Abfragefrequenz wird erhöht. Der Energiebedarf der letztgenannten Elektroden wird so auf ein Maß reduziert, welches einerseits eine Energieeinsparung ermöglicht und andererseits (im Gegensatz zu einer Abschaltung) die Kalibrierung dieser Elektroden jederzeit gewährleistet. Welche der Elektroden mit höherer Frequenz betrieben werden als die übrigen Elektroden, ist in Abhängigkeit von der Anordnung der Elektroden am Fahrzeug und der gewünschten Detektion zu bestimmen. Es kann eine Elektroden als hochfrequente Weckelektrode wirken, welche einen sich nähernden Benutzer als erstes erfassen müsste, dies führt jedoch ggf. zu einer häufigen Fehlweckung, wenn eine sich nähernde Person gar keine Bedienung beabsichtigt (vorbeilaufende Passanten). Andererseits kann eine Sensorelektrode als Weckelektrode getaktet werden, welche einen weniger zugänglichen Bereich überwacht, z.B. unterhalb des Fahrzeuges. Dies verringert die Anzahl der Fehlaktivierung oder Hochtaktung der übrigen Elektroden, kann jedoch zu Verzögerungen oder sogar dem Verpassen von Betätigungen führen. Die gewünschte Verhaltensweise kann jedoch für einen Benutzer oder für Wartungspersonal über ein Bordsystem einstellbar sein. Ist z.B. maximale Energieeinsparung gewünscht, wird die Elektrodenanordnung nach einer vorgegebenen Zeitdauer (z.B. nach einigen Stunden) in den Sparbetrieb geschaltet, wobei dann nur eine der Elektroden im geweckten oder hochfrequenten Modus arbeitet. Die anderen Elektroden werden bis zu mehreren Größenordnungen, z.B.um einen Faktor 3, 10 oder 50 langsamer getaktet. Wird ein solches Fahrzeug für mehrere Tage an einem Ort abgestellt (z.B. Flughafen) ist eine erhebliche Energiebedarfsreduzierung möglich. Sämtliche Elektroden bleiben jedoch jederzeit kalibriert, auch bei niedrigerer Frequenz. Ein zurückkehrender Benutzer muss jedoch ggf. eine Bewegungsgeste zweimal ausführen, da die taktreduzierten Elektroden keine zeitaufgelöste Erfassung mit ausreichender Auflösung erlauben. Die Weckelektrode detektiert jedoch die erste Geste und bring die anderen Elektroden in einen geweckten Zustand, so dass die zweite Bewegungsgeste ordnungsgemäß detektiert werden kann. Erfolgt der Weckvorgang rasch genug, kann auch schon der erste Betätigungsvorgang detektiert werden.

Die erfindungsgemäße Einrichtung ermöglicht verschiedene Arten der Auswertung, einerseits über die Signalstärke von beiden Elektroden und andererseits über die Signalfolge. Insbesondere kann überwacht werden, welche Elektrode als erste auf eine Zustandsänderung anspricht. Über die bekannte räumliche Anordnung der Elektroden kann eine Differenzierung vorgenommen werden. Bei der Erfindung verändert die Steuer- und Auswerteeinrichtung die Taktrate der Ansteuerung- und Auswertung einzelner Elektroden in Abhängigkeit von den Ergebnissen der Auswertung an anderen Elektroden.

Die Taktveränderung einzelner Elektroden von der Detektion an anderen Elektroden abhängig zu machen erlaubt eine verbesserte Energieeffizienz. Wie oben beschrieben kann eine dauerhaft hochgetaktete Weckelektrode als Kriterium für die Taktung der anderen Elektroden herangezogen werden. Diese anderen Elektroden werden dann unabhängig von deren Erfassung in ihrer Taktrate reduziert. Es werden also nicht nur signalfreie Elektroden in ihrer Taktfrequenz herabgesetzt, sondern es können auch Elektroden in einen Sparmodus versetzt werden, obwohl diese wiederholt Signale liefern. Dies ist insbesondere dann sinnvoll, wenn die Weckelektrode an einem weniger zugänglichen Überwachungsraum angeordnet ist, der z.B. einen Bereich unterhalb des Stoßfängers eines Fahrzeuges überwacht. So ist selbst in belebten Umgebungen, z.B. einem Parkhaus mit häufigem Passantenverkehr die Energieeinsparung durch die Weckelektrode sichergestellt, da diese durch Passanten nicht ausgelöst wird, auch wenn diese den Erfassungsbereich der anderen Elektroden durchqueren.

Eine besonders bevorzugte Gestaltung der Erfindung nutzt die Steuer- und Auswerteeinrichtung zur Verminderung der Taktrate der Ansteuerung der sekundären Elektroden für den Fall, dass die Auswertung einer primären Sensorelektrode (Weckelektrode) für einen vorgegebenen Zeitraum keine Betätigung anzeigt.

Statt die Reduzierung der Taktraten von Elektroden davon Abhängig zu machen, dass sämtliche oder die betreffenden Elektroden keine Detektion liefern, wird die Detektion der Weckelektrode einer einfachen Zeitüberwachung zugeführt. Werden für einen vorgegebenen Zeitraum (einige Stunden) keine signifikanten Signaländerungen erfasst, wird die Erfassungshäufigkeit der anderen Elektroden reduziert. Diese Zeitüberwachung kann auch mehrstufig erfolgen, nach einem oder mehreren Tagen ohne Detektion kann z.B. die Taktung der anderen Elektroden weiter reduziert werden. Auch die Taktung der Weckelektrode kann z.B. nach einer vorgegebenen Zeitdauer auf einen geringeren Wert gesetzt werden. Außerdem kann in jeder Ausbildung der Erfindung der Wechsel in den energiereduzierten Modus von weiteren Fahrzeugparametern, z.B. der Fahrzeugverriegelung abhängig gemacht werden.

In einer Gestaltung der Erfindung ist die weckende Sensorelektrode in geringerem Abstand zu einem überwachten Erfassungsbereich angeordnet ist als die sekundären (taktreduzierten) Sensorelektroden.

In dieser Gestaltung steht im Vordergrund, dass jederzeit eine zuverlässige Erfassung möglich ist, ohne dass ggf. eine Doppelbetätigung zur Aktivierung sämtlicher Elektroden erforderlich ist (siehe oben). Diese Alternative hat weniger Einsparpotenzial, da eine fehlerhafte Auslösung der Weckelektrode durch den weitreichenden Erfassungsbereich häufiger vorkommt als bei einer Elektrode mit weniger zugänglichem Erfassungsbereich. Diese Gestaltung kann jedoch auch als alternativer Modus zu dem vorgenannten Modus über eine Einstellung im Bordsystem verfügbar sein.

Das erfindungsgemäße Verfahren zum Erfassen von Annäherungen und Bewegungsgesten eines Benutzers an einem Kraftfahrzeug nutzt eine kapazitive Sensoranordnung der oben genannten Art und wenigstens eine mit der Sensoranordnung gekoppelten Steuereinrichtung. Als Teil der Sensoranordnung werden wenigstens zwei Sensorelektroden an verschiedenen Positionen des Fahrzeugs angeordnet. Die Änderungen der Kapazität der Sensoranordnung gegenüber einem Referenzpotential werden überwacht. Durch getaktetes Ansteuern und Abfragen einer ersten Sensorelektrode mit einer ersten Taktrate wird die erste Sensorelektrode aufgeladen und entladen und ein Strom- oder Spannungsverlauf wird aufgenommen. Dieser wird zur Erfassung der Kapazitätsänderung der ersten Sensorelektrode ausgewertet.

Falls die Auswertung keine signifikante Signalantwort ergibt (also eine solche, welche eine Bedienung durch einen Benutzer anzeigen kann), wird geprüft, welcher Zeitraum bereits ohne Detektion an der ersten Elektrode verstrichen ist. Für den Fall, dass für einen vorgegebenen Mindestzeitraum (Zeitraum Mt) keine signifikante Signalantwort erhalten wurde, wird die Taktrate zur Ansteuerung weiterer Sensorelektroden der Sensoranordnung auf eine reduzierte Taktrate verringert.

Wurde jedoch eine signifikante Signalantwort erhalten, wird die Taktrate zur Ansteuerung solcher weiterer Sensorelektroden der Sensoranordnung erhöht, welche zuvor mit reduzierter Taktrate angesteuert werden.

Vorteilhafte und/oder bevorzugte Ausführungsformen sind in den Unteransprüchen gekennzeichnet.

Die Erfindung wird nun anhand der beiliegenden Figuren näher erläutert.
Figur 1a zeigt die Anordnung einer ersten Ausführungsform der erfindungsgemäßen Sensoranordnung an einem Kraftfahrzeug;
Figur 1b zeigt die Anordnung aus Figur 1 in einer schematischen Aufsicht;
Figur 1c zeigt die Anordnung aus den Figuren 1a und 1b in einer schematischen Aufsicht mit dargestellten Erfassungsbereichen;
Figur 2 zeigt eine schematische Darstellung einer Signalfolge von zwei Sensorelektroden;

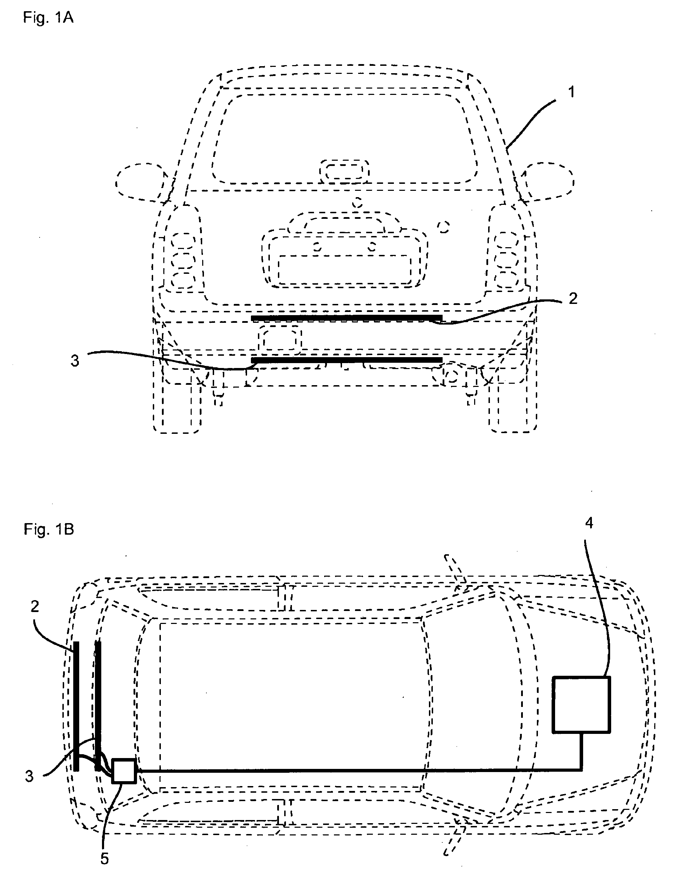

In Figur 1a ist das Heck eines Fahrzeugs 1 gezeigt. Bereich des Heckstoßfängers ist eine Sensorelektrodenanordnung 2 angebracht. Unterhalb (also in geringerer Höhe vom Boden) der Sensorelektrodenanordnung 2 ist eine weitere Sensorelektrode 3 angeordnet. Die Sensorelektroden 2 und 3 sind jeweils mit einer Steuer- und Auswerteeinrichtung 5 verbunden (siehe Figur 1B). Diese ist wiederum mit einer zentralen Fahrzeugsteuereinheit 4 gekoppelt, welche eine Öffnung der Heckklappe des Fahrzeugs kontrolliert und freigibt. Die Elektroden werden über die Einrichtung 5 aufgeladen und die Kapazitätsänderung der Elektroden bei Annäherung eines Körpers, z.B. eines Bedienerkörperteils kann durch Ladungsauswertung erfasst werden. Dieses Prinzip eines kapazitiven Sensors ist im Bereich der Kraftfahrzeugtechnik bekannt.

Die Sensorelektrodenanordnung 3 verläuft im Wesentlichen parallel zu der Elektrode 2. Die Elektroden 2 und 3 sind hier durchgehend mit im Wesentlichen gleichbleibender Empfindlichkeit ausgebildet. Eine oder beide der Elektroden könnten jedoch auch als segmentierte Elektroden ausgebildet sein, deren Erfassungsempfindlichkeit in Längsrichtung variiert, also in Richtung der Erstreckung des Stoßfängers Bereiche mit wechselnder Erfassungssensitivität aufweist.

Bei einem Bedienwunsch kann ein Bediener seinen Unterschenkel in einer Schwenkbewegung unter den Stoßfänger bewegen. Diese Bewegung und Annäherung wird sowohl durch die Elektrodenanordnung 2 erfasst, als auch durch die Sensorelektrode 3, da die Kapazitätsänderung zeitlich wiederholt abgefragt und die Veränderung ausgewertet wird. Von jeder der Elektroden wird durch wiederholte Abfrage eine Kapazität ermittelt. Die Frequenz der Abfrage beträgt in diesem Beispiel zunächst für alle Elektroden 30Hz. In jeder der Elektroden wird die Bedienung jedoch zeitlich und betragsmäßig verschiedene Signalantworten hervorrufen.

Eine Zeitfolge von Kapazitätswerten, welche die Auswerteeinrichtung 5 sammelt, wird zur Erfassung von charakteristischen Merkmalen einer Bediengeste ausgewertet. Zeigen sowohl die Signalfolgen der Elektrode 2 als auch die der Elektrode 3 die charakteristischen Werte, erfolgt eine Signalisierung an die Steuereinheit 4. Diese registriert die Bediengeste und leitet eine Abfrage einer Autorisierung ein. In deren Zuge werden ID-Geber, welche ein autorisierter Benutzer bei sich trägt, in der Umgebung des Fahrzeugs abgefragt. Wird ein solcher ID-Geber mit Zugangsberechtigung ermittelt und erfolgreich abgefragt, so wird die Öffnung des Kofferraumdeckels veranlasst.

Wird jedoch das Fahrzeug verriegelt und außerdem von der Elektrode 3 für längere Zeit, in diesem Beispiel für mehr als sechs Stunden, keine Signalantwort die eine Bedienung dieser Elektrode anzeigt registriert, so wechselt die Steuer- und Auswerteeinrichtung 5 in einen ersten Energiesparmodus. In diesem ersten Modus wird die Elektrode 3 weiterhin mit 30HZ abgefragt, die Elektrode 2 wird jedoch nur noch mit 5 Hz abgefragt. Diese verringerte Frequenz reduziert die erforderliche Energieeinspeisung in diese Elektrode und gewährleistet dennoch, dass die Steuer- und Auswerteeinrichtung 5 fünf Werte pro Sekunde von dieser Elektrode erhält. Auf Basis dieser Werten kann eine kontinuierlich nachgeführte Kalibrierung dieser Elektrode erfolgen. Setzt um das parkende Auto z.B. ein Regenfall ein, so werden sich die Kapazitätswerte der Elektroden verändern, jedoch so langsam, dass eine Kalibrierung problemlos nachgeführt werden kann. Die Kalibrierung erfolgt z.B. durch Bildung eines gleitenden Mittelwertes über die 25 zuletzt erfassten Werte (5 Sekunden). Dieser Mittelwert kann als Offset von den aktuellen Messwerten abgezogen werden.

Wird an der Elektrode 3 für noch deutliche längere Zeit, z.B. drei Tage keine Bedienung erfasst (und das Fahrzeug auch nicht durch sonstige Zugriffsmöglichkeiten, z.B. über die Fahrertüren, entriegelt), kann die Erfassungsfrequenz sowohl der Elektrode 3 als auch der Elektrode 2 weiter reduziert werden. Beispielsweise wird die Abfragefrequenz für die Elektrode 3 auf 10 Hz verringert und die Frequenz der Elektrode 2 bleibt bei 5 Hz. In diesem Fall kann es bei einer Bedienung ohne vorherige Ankündigung an das Fahrzeug (z.B. über ID-Geber) jedoch nötig sein, dass eine Bediengeste mehrmals ausgeführt werden muss, da zunächst die Elektrodenanordnung geweckt werden muss. Dennoch sind die Elektroden jederzeit in einem kalibrierten Zustand, auch wenn die Erfassungstaktung reduziert ist.

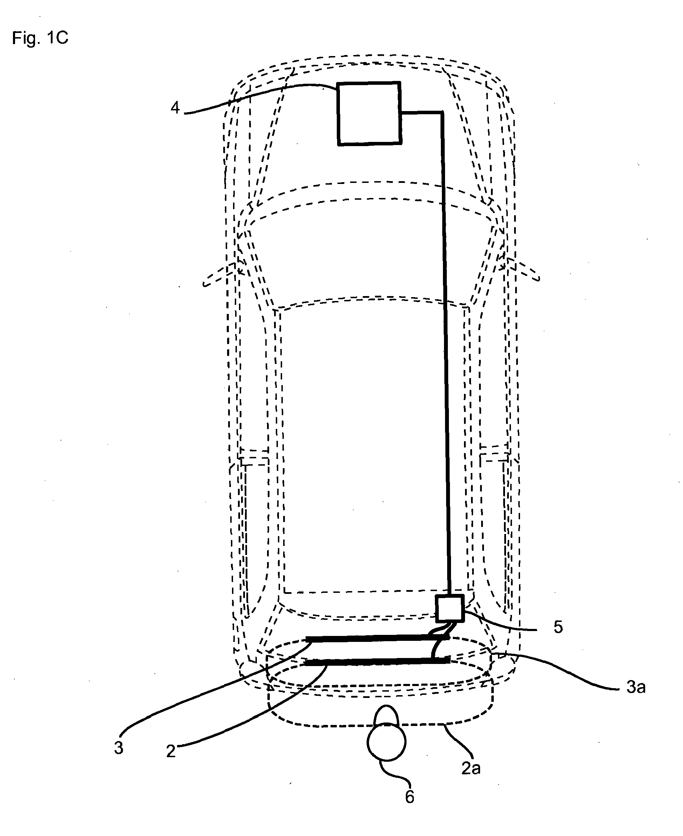

Figur 1C, zeigt die Anordnung aus einer anderen Ansicht. Hier ist der Erfassungsraum 3a der Elektrode 3 und der Erfassungsraum 2a der Elektrode 2 dargestellt. Der Unterschenkel 6 eines Bedieners ist symbolisch gezeigt. Aus dieser Darstellung geht hervor, dass der Bediener sich bereits im Detektionsraum 2a, jedoch nicht im Detektionsraum 3a befindet. Wäre der Bediener 6 ein Passant, würde diese Annäherung noch nicht zu einer Weckung der Sensorelektroden führen, denn in diesem Beispiel ist die Elektrode 3 als Weck- oder Triggerelektrode ausgebildet, da ihre zufällige oder ungezielte Auslösung weniger wahrscheinlich ist als bei Elektrode 2. Welche Elektrode jedoch als hochgetaktete Triggerelektrode wirken soll, kann durch Bestimmung verschiedener Abfragemodi im Bordsystem des Fahrzeugs festgelegt werden, je nachdem, ob maximale Energieeinsparung oder maximale Erkennungsbereitschaft erwünscht ist. Wird die Elektrode 2 als Weckelektrode gewählt, so wird diese gezeigte Annäherung zu einer Weckung aller Sensorelektroden führen, wobei die jederzeit kalibrierten Elektroden sofort detektionsbereit sind.

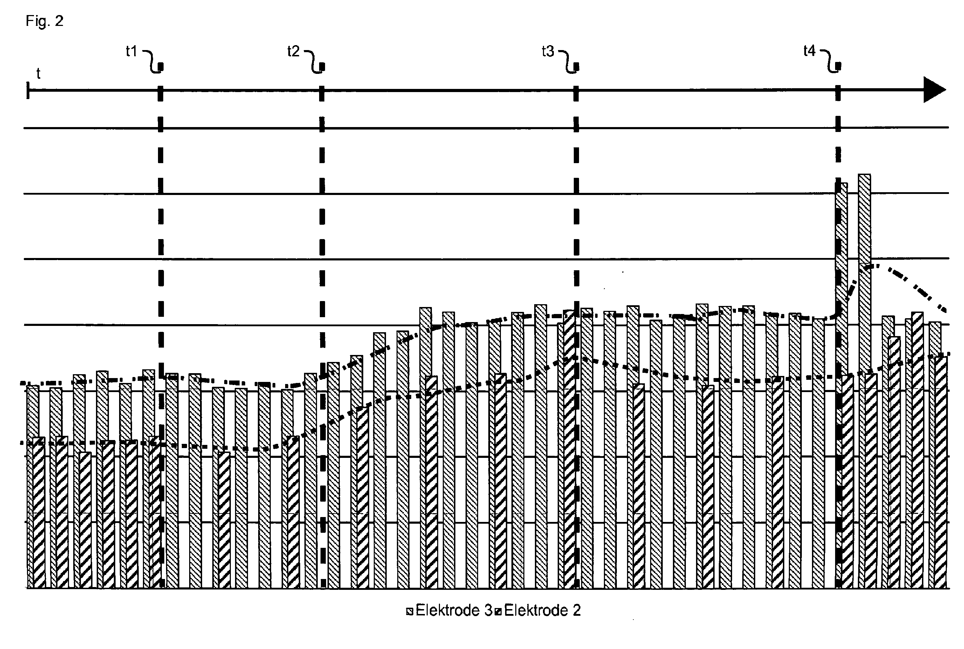

Figur 2 zeigt eine abstrahierte mögliche Signalfolge für eine Sensoranordnung mit zwei Sensorelektroden. Die Signalstärken oder Kapazitäten sind entlang einer Zeitachse t dargestellt.

Die Signale der Elektrode 3 sind im Hintergrund dargestellt (leichtete Schraffur) während die Signale der Elektrode 2 im Vordergrund (stärkere Schraffur) gezeigt sind.

Zunächst werden beide Elektroden mit gleicher Frequenz abgefragt. Zum Zeitpunkt t1 ist eine Wartezeit Mt nach Verriegelung des Fahrzeuges vergangen und die Abfragefrequenz der Elektrode 2 wird gegenüber der Frequenz der Elektrode 3 auf ein Drittel reduziert. Der Energieverbrauch des Systems ist damit verringert.

Bei t2 verändern sich die Umgebungsbedingungen der Anordnung, es beginnt z.B. zu Regnen. Die Offsetwerte für beide Elektroden erhöhen sich, was eine kontinuierliche Kalibrierung bei beiden Elektroden jedoch berücksichtigt. Da auch die Elektrode 2, wenn auch mit geringerer Frequenz, abgefragt wird, wird die Kalibrierung mitgezogen und der Offset jederzeit für eine Erfassung einer Betätigung aktualisiert. Die gleitenden Durchschnitte, welche jederzeit für beide Elektroden berechnet werden, sind beispielhaft dargestellt.

Es ist zu erkennen, dass bei t3 in der Elektrode 2 eine signifikante Signaländerung auftritt. Da diese Elektrode jedoch nicht die Weckelektrode ist und bei Elektrode 3 keine signifikante Änderung detektiert wird, bleibt die Elektrode 3 in dem taktreduzierten Modus. Dieser Vorgang kann z.B. durch einen Passanten hervorgerufen werden, welcher sich am Fahrzeug vorbei bewegt.

Bei Zeitpunkt t4 zeigt die Elektrode 3 eine signifikante Änderung, welche eine Betätigung anzeigen könnte. Sofort wird die Taktung der Abfrage von Elektrode 2 erhöht, um eine Betätigung erfassen zu können. Bei erfolgreicher Abfrage, wird von der zentralen Steuereinrichtung die Öffnung des Kofferraums angesteuert.

## Patentansprüche

1. Sensoranordnung zur Erfassung von Annäherungen und Bewegungsgesten eines Benutzers an einem Kraftfahrzeug, mit
einer kapazitiven Sensoranordnung (2, 3) und wenigstens einer mit der Sensoranordnung gekoppelten Steuer und Auswerteeinrichtung (5), die eine Änderung der Kapazität der Sensoranordnung erfasst,
wobei die Sensoranordnung wenigstens zwei Sensorelektrodenanordnungen (2, 3) aufweist, die an räumlich versetzten Positionen am Kraftfahrzeug angeordnet sind, wobei die Sensorelektroden (2, 3) als längliche Elektrodenanordnungen ausgebildet und mit gleicher Raumorientierung angeordnet sind,
wobei die Steuer- und Auswerteeinrichtung zur getakteten Ansteuerung der Sensorelektroden in vorgegebenen Zeitabständen ausgebildet ist, wobei
die Steuer- und Auswerteeinrichtung zur Ansteuerung und Auswertung der Sensorelektroden mit veränderbaren, elektrodenspezifisch unterschiedlichen Taktraten ausgebildet ist, **dadurch gekennzeichnet, dass** die Steuer- und Auswerteeinrichtung die Taktrate der Ansteuerung- und Auswertung einzelner Elektroden in Abhängigkeit von den Ergebnissen der Auswertung an anderen Elektroden verändert.

2. Sensoranordnung nach Anspruch 1, wobei eine der Elektroden als primäre Sensorelektrode von der Steuer- und Auswerteeinrichtung mit einer ersten Taktrate ansteuerbar und auswertbar ist und wenigstens eine sekundäre Elektrode in Abhängigkeit von der Auswertung der Signale der primären Sensorelektrode mit einer geringeren zweiten Taktrate ansteuerbar ist.

3. Sensoranordnung nach Anspruch 2, wobei die Steuer- und Auswerteeinrichtung zur Verminderung der Taktrate der Ansteuerung der sekundären Elektroden für den Fall ausgebildet ist, dass die Auswertung der primären Sensorelektrode für einen vorgegebenen Zeitraum keine Betätigung anzeigt.

4. Sensoranordnung nach einem der Ansprüche 2 oder 3, wobei die primäre Sensorelektrode in geringerem Abstand zu einem überwachten Erfassungsbereich angeordnet ist als die sekundären Sensorelektroden.

5. Sensoranordnung nach einem der vorstehenden Ansprüche, wobei wenigstens eine der Sensorelektroden in einem Stoßfänger eines Kraftfahrzeuges angeordnet ist.

6. Verfahren zum Erfassen von Annäherungen und Bewegungsgesten eines Benutzers an einem Kraftfahrzeug, wobei eine kapazitiven Sensoranordnung (2, 3) und wenigstens eine mit der Sensoranordnung gekoppelten Steuer und Auswerteeinrichtung (5) vorgesehen ist, die eine Änderung der Kapazität der Sensoranordnung erfasst, wobei wenigstens zwei Sensorelektrodenanordnungen (2, 3) an räumlich versetzten Positionen am Kraftfahrzeug angeordnet sind, wobei die Sensorelektroden (2, 3) als längliche Elektrodenanordnungen ausgebildet und mit gleicher Raumorientierung angeordnet sind,
aufweisend die Schritte:
getaktetes Ansteuern und Abfragen einer ersten Sensorelektrode mit einer ersten Taktrate, wobei die erste Sensorelektrode Aufgeladen und Entladen wird und ein Strom- oder Spannungsverlauf aufgenommen wird,
Auswerten des Strom- oder Spannungsverlaufs zur Erfassung der Kapazitätsänderung der ersten Sensorelektrode,
falls die Auswertung keine signifikante Signalantwort ergibt, welche eine Annäherung eines Benutzers in den Erfassungsbereich anzeigt,
- für den Fall, dass für einen vorgegebenen Mindestzeitraum keine signifikante Signalantwort erhalten wurde, Verringern der Taktrate zur Ansteuerung weiterer Sensorelektroden der Sensoranordnung auf eine reduzierte Taktrate;
- für den Fall, dass eine signifikante Signalantwort erhalten wurde, Erhöhen der Taktrate zur Ansteuerung derjenigen weiterer Sensorelektroden der Sensoranordnung, welche noch mit reduzierter Taktrate angesteuert werden.

## Claims

1. A sensor arrangement for detecting approaches and control gestures of a user for a motor vehicle, with a capacitive sensor arrangement (2, 3) and at least one control and evaluation means (5) coupled with the sensor arrangement, which detects a change in the capacity of the sensor arrangement,
wherein the sensor arrangement comprises at least two sensor electrode arrangements (2, 3) which are arranged at spatially offset positions on the vehicle, the sensor electrodes (2, 3) being configured as elongate electrode arrangements and arranged with the same spatial orientation,
wherein the control and evaluation means is configured for clocked control of the sensor electrodes at preset time intervals, the control and evaluation means being configured for control and evaluation of the sensor electrodes at variable, electrode-specifically different clock rates,
**characterised in that** the control and evaluation means varies the clock rate for control and evaluation of individual electrodes as a function of the results of the evaluation of other electrodes.

2. The sensor arrangement according to claim 1, wherein one of the electrodes, as the primary electrode, can be controlled and evaluated at a first clock rate and at least one secondary electrode can be controlled as a function of the evaluation of the signals of the primary sensor electrode at a lesser second clock rate.

3. The sensor arrangement according to claim 2, wherein the control and evaluation means is configured for reducing the clock rate of the control of the secondary electrodes in the case that the evaluation of the primary sensor electrode does not indicate any actuation for a predefined period of time.

4. The sensor arrangement according to one of claims 2 or 3, wherein the primary sensor electrode is arranged at a lesser distance from a monitored detection range than the secondary sensor electrodes.

5. The sensor arrangement according to one of the preceding claims, wherein at least one of the sensor electrodes is arranged in a shock absorber of a motor vehicle.

6. A method for detecting approaches and movement gestures of a user at a motor vehicle, wherein a capacitive sensor arrangement (2, 3) and at least one control and evaluation means (5) coupled with the sensor arrangement is provided, which detects a change in the capacity of the sensor arrangement, wherein at least two sensor electrode arrangements (2, 3) are arranged at spatially offset positions on the vehicle, the sensor electrodes (2, 3) being configured as elongate electrode arrangements and arranged with the same spatial orientation, comprising the steps of:
clocked controlling and polling a first sensor electrode at a first clock rate, wherein the first sensor electrode is charged and discharged and a current or voltage progression is recorded,
evaluating the current and voltage progression for detecting the capacity change of the first sensor electrode,
if the evaluation does not result in a significant signal response indicating that a user is approaching the detection range,
- lowering, in case no significant signal response has been obtained for a predefined minimum period of time, the clock rate for controlling further sensor electrodes of the sensor arrangement to a reduced clock rate;
- increasing, in case a significant signal response has been obtained, the clock rate for controlling those further sensor electrodes which are still controlled at a reduced clock rate.

## Revendications

1. Agencement de capteur pour la détection d'approches et de gestes d'un utilisateur au niveau d'un véhicule automobile, avec
un agencement de capteur capacitif (2, 3) et au moins un dispositif de commande et d'évaluation (5) couplé avec l'agencement de capteur, lequel détecte une modification de la capacité de l'agencement de capteur,
dans lequel l'agencement de capteur présente au moins deux agencements d'électrodes de capteur (2, 3), lesquels sont disposés dans des positions décalées dans l'espace sur le véhicule automobile, les électrodes de capteur (2, 3) étant réalisées en tant qu'agencements d'électrodes oblongs et étant disposées selon une orientation spatiale identique,
le dispositif de commande et d'évaluation étant réalisé pour la commande cadencée des électrodes de capteur à intervalles de temps prescrits,
le dispositif de commande et d'évaluation étant réalisé, pour la commande et l'évaluation des électrodes de capteur, avec des rythmes d'horloge spécifiquement différents selon les électrodes,
**caractérisé en ce que** le dispositif de commande et d'évaluation modifie le rythme d'horloge de la commande et de l'évaluation d'électrodes individuelles en fonction des résultats de l'évaluation au niveau d'autres électrodes.

2. Agencement de capteur selon la revendication 1, l'une des électrodes pouvant être commandée et évaluée, en tant qu'électrode de capteur primaire du dispositif de commande et d'évaluation, à un premier rythme d'horloge et au moins une électrode secondaire pouvant être commandée à un deuxième rythme d'horloge inférieur en fonction de l'évaluation des signaux de l'électrode de capteur primaire.

3. Agencement de capteur selon la revendication 2, le dispositif de commande et d'évaluation, pour la diminution du rythme d'horloge de la commande des électrodes secondaires, étant réalisé pour le cas où l'évaluation de l'électrode de capteur primaire n'affiche pas d'actionnement pour un laps de temps prescrit.

4. Agencement de capteur selon l'une des revendications 2 ou 3, l'électrode de capteur primaire étant disposée à une plus faible distance d'une zone de détection surveillée que les électrodes de capteur secondaires.

5. Agencement de capteur selon l'une des revendications précédentes, dans lequel au moins l'une des électrodes de capteur est disposée dans un pare-chocs d'un véhicule automobile.

6. Procédé pour la détection d'approches et de gestes d'un utilisateur au niveau d'un véhicule automobile, dans lequel on prévoit un agencement de capteur capacitif (2, 3) et au moins un dispositif de commande et d'évaluation (5) couplé avec l'agencement de capteur, lequel détecte une modification de la capacité de l'agencement de capteur, au moins deux agencements d'électrodes de capteur (2, 3) étant disposés dans des positions décalées spatialement sur le véhicule automobile, les électrodes de capteur (2, 3) étant réalisées en tant qu'agencements d'électrodes oblongs et étant disposées selon une orientation spatiale identique,
présentant les étapes suivantes :
la commande cadencée et l'interrogation d'une première électrode de capteur à un premier rythme d'horloge, la première électrode de capteur étant chargée et déchargée et une variation du courant ou de la tension étant enregistrée,
l'évaluation de la variation du courant ou de la tension pour la détection de la modification de la capacité de la première électrode de capteur,
si l'évaluation ne donne pas de réponse de signal significative indiquant une approche d'un utilisateur dans la zone de détection,
- dans le cas où aucune réponse de signal significative n'a été obtenue pendant un laps de temps minimal prescrit, diminution du rythme d'horloge pour la commande d'autres électrodes de capteur de l'agencement de capteur jusqu'à un rythme d'horloge réduit ;
- dans le cas où une réponse de signal significative a été obtenue, augmentation du rythme d'horloge pour la commande de celles des autres électrodes de capteur de l'agencement de capteur, lesquelles sont encore commandées à un rythme d'horloge réduit.
